# EUROPEAN PATENT SPECIFICATION

(11) **EP 2 139 955 B1**
(45) Date of publication and mention of the grant of the patent: **13.05.2020**
(21) Application number: 08748996.9
(22) Date of filing: 18.04.2008
(51) Int. Cl.: C09D 5/24, C01B 32/00, H01L 51/52, G01N 27/30, H01L 31/0224

(54) **HIGHLY CONDUCTIVE, TRANSPARENT CARBON FILMS AS ELECTRODE MATERIALS**
HOCH LEITFÄHIGE TRANSPARENTE KOHLENSTOFFFILME ALS ELEKTRODENMATERIALIEN
FILMS DE CARBONE TRANSPARENTS, HAUTEMENT CONDUCTEURS, COMME MATIÈRES D'ÉLECTRODE

(30) Priority: 20.04.2007 WO PCT/EP2007/003491
(43) Date of publication of application: 06.01.2010
(73) Proprietor: Beijing Jingchenghongye Technology Co. Ltd., 100195, Beijing (CN)
(72) Inventor: MÜLLEN, Klaus, D-50939 Köln (DE); WANG, Xuan, Shanghai, 201203 (CN); ZHI, Linjie, 55122 Mainz (DE)
(74) Representative: Weickmann & Weickmann PartmbB
(86) International application number: PCT/EP2008/003150
(87) International publication number: WO 2008/128726

(56) References cited:
- EP-A- 1 063 196
- DONNER S: "Fabrication of Optically Transparent Carbon Electrodes by the Pyrolysis of Photoresist Films: Approach to Single-Molecule Spectroelectrochemistry" ANALYTICAL CHEMISTRY, vol. 78, no. 8, 15 April 2006 (2006-04-15), pages 2816-2822, XP002463388 cited in the application

## Description

The present invention relates to an optically transparent conductive carbon-based film, a process for the production thereof and the application of the film as electrode in optoelectronic devices.

Optically transparent electrodes consisting of thin conductive films which are deposited on transparent substrates have been the subject of intense research. These film systems are of particular interest for use in for example flat panel displays, photovoltaic cells, electrochromic devices, electroluminescent lamps and a large number of further applications. For these applications, transparent electrodes must exhibit three important qualities: high optical transparency, electrical conductivity and mechanical durability.

The most commonly used material in optically transparent conductive films is indium-tin oxide (ITO). However, due to the high cost and limited supply of indium, alternatives are being sought for modern optoelectronic devices. So far, development of different inorganic and polymer layers as well as films of carbon nanotubes has been investigated. The use of carbon materials is particularly attractive since carbon is easily available, cheap and inert. The low electrical resistance and at the same time high optical transparency are essential for good application properties of carbon films. These two properties, however, are oppositely influenced by the film thickness. Films had to be sufficiently thick to provide low electrical resistance for reasonable electrochemical properties, yet had to be sufficiently thin to maintain high optical transparency. The layer thickness was chosen to obtain a compromise between the two desired properties.

Carbon has been used as an electrode material for a range of applications. The popularity can be traced to the versatility and availability of many types of carbon which can easily be fabricated into electrodes. Carbon materials also provide renewable and reproducible surfaces as well as low chemical reactivity.

Carbon-based optically transparent electrodes (OTEs) have been developed for spectroelectrochemical studies (Matthias Kummer and Jon R. Kirchhoff, Anal. Chem. (1993), 65, 3720-3725). Pyrolytic graphite-coated electrodes were prepared by vapor deposition of acetone as carbon precursor onto resistively heated metal mesh substrate, whereby a thin layer of graphite was deposited on the heated metal mesh.

Another approach was the provision of reticulated vitreous carbon electrodes (Janet Weiss Sorrels and Howard D. Dewald, Anal. Chem. (1990), 62, 1640-1643). Reticulated vitreous carbon (RVC) is a porous, vitreous carbon foam material. For use as electrodes it is sliced to slides having a thickness of about 0.5 to 3.5 mm.

Further, carbon optically transparent electrodes have been prepared by vapor deposition of a thin carbon film on a glass or quartz substrate (J. Mattson et al., Anal. Chem. (1975) Vol. 47 No. 7, 1122-1125; T.P.

DeAngelis et al., Anal. Chem. (1977), Vol. 49, No. 9, 1395-1398). The carbon was evaporated by an electron beam technique using a glassy carbon source and the evaporated carbon was then deposited as carbon film onto substrates.

Further, optically transparent carbon film electrodes were prepared by forming a carbon film on a quartz substrate by a vacuum pyrolysis of 3, 4, 9, 10-perylenetetracarboxylic dianhydride (D. Anjo et al., Anal. Chem. (1993), 65, 317-319). The carbon source 3, 4, 9, 10-perylenetetracarboxylic dianhydride was sublimed and then vapor-pyrolized at 800°C on the surface of a quartz substrate producing a mirror-like conductive coating.

EP 1 063 196 describes a carbonaceous complex structure comprising a layered set of a substrate, a carbonaceous thin film and a fullerene thin film. The films are obtained by thermally decomposing carbon compounds such as fullerene molecules or organic solvents, such as ethanol or toluene. The conductivity of the carbonaceous films described in EP 1 063 196 is in the order to 10⁻²S/cm. Such a low conductivity, however, is not sufficient to make the carbonaceous film of EP 1063196 suitable as a transparent electrode in optoelectronic devices, such as solar cells.

Donner et al., (Anal. Chem. (2006) Vol. 78, No. 8, 2816-2822) describe the preparation of carbon-based optically transparent electrodes fabricated by pyrolysis of thin films of photoresists. The photoresist AZ 4330 was spin coated onto quartz substrates and a carbon film was produced by pyrolysis in a reducing atmosphere. The photoresist AZ 4330 is a cresol-novolak resin with highly branched structures and the reaction of this polymer with diazonaphthoquinonosulfonic esters results in a hard amorphous carbon structure. The films obtained by this course of action show a low transparency, for example a transparency of only 47% for a 13 nm thick carbon film. Such low transparency cannot meet the demand of modern optoelectronic devices.

As we know, a compromise between electrical resistance and optical transparency had to be accepted with all known methods due to their dependence on the carbon film thickness. Generally, resistance of carbon films undergoes a dramatic increase as thickness decreases below around 30 nm. Therefore, hitherto reported carbon films even in the thickness of ∼13nm, with sheet resistance in the range of 1000-2000 ohm/ sq, have transmittance lower than 55%. Since these reported carbon film electrodes were only used in spectroelectrochemical studies, such transparency was enough. However, such low transparency cannot meet demand of modern devices such as optoelectronic devices. Besides high transparency, modern devices require transparent electrodes with low resistance, smooth surface as well as suitable work function which depends strongly on the structure of carbon film. Obviously, the type of precursor and preparing methods are important for fabrication of structure-controllable carbon films. Furthermore, most of the reported methods for preparing transparent carbon films are complicated.

The art therefore seeks suitable precursors and simple procedures for making highly transparent, conductive and structure-controllable carbon films with smooth surface and appropriate work function for modern device application, in particular for use in optoelectronic devices.

The object of the present invention is therefore to provide a thin highly transparent and conducting carbon film which also has suitable work function for optoelectronic devices. A further object was to provide such a carbon film in an easy, cheap and reproducible way.

This object of the invention is solved by a method for the production of a transparent conductive carbon film comprising the steps (i) coating of a solution of discotic precursors onto a substrate and(ii) heating the coated substrate under a protective gas to a temperature of from 400-2000°C,wherein the produced transparent carbon film has a transmittance in the range of 60-95%, for a carbon film having a thickness of 30 nm-4 nm at a wavelength of 700 nm and wherein the produced carbon film has a sheet resistance of at most 30 kohm/sq, and wherein the discotic precursors are selected from superphenalenes, hexabenzocoronenes (HBC), ovalenes, coronenes, perylenes, pyrenes, and their derivatives; pitches, heavy oils from coal or petroleum; or exfoliated graphite from chemical or physical exfoliation of any graphite or from graphite oxide. Further preferred embodiments of the invention are set out in dependent claims 2-9. The invention provides a simple, cheap and reliable method producing optically transparent conductive carbon films. In the inventive process, the thickness of the carbon film produced can easily be controlled by concentration of the solution of discotic precursors or by the repetition of the steps (i) and (ii). Further, the size of the film sheets is only limited by the size of the substrates used. Further, the carbon film obtained according to the inventive process has a higher thermal and chemical stability than traditionally used ITO. Further, it has an extremely smooth surface, which can e.g. not be obtained with carbon nanotube films. With the inventive method, it is possible to provide conductive carbon films having both a high transparency and at the same time a low electrical resistance.

The transmittance of the carbon film produced is preferably at least 70%. According to the present invention, the transmittance of the carbon film is in the range of 60-95%. The transmittance of a material is dependent on the respective wave length. The transmittance values indicated herein refer to a wave length of 500-800 nm, particularly to a wave length of 600-700 nm, and particularly to a wave length of 700 nm, unless otherwise noted. Further, the transmittance is dependent on the film thickness. The transmittance values indicated herein refer to a film thickness of ≤ 30 nm and 5 ≥ nm, in particular 10 ≥ nm and in particular to a film thickness of 30 nm unless otherwise noted.

Unlike carbon-based films of the prior art, the sheet resistance of the carbon films of the invention is quite small, even if the thickness decreases. For example, the sheet resistance of carbon films grown from discotic molecules on SiO₂/Si substrates was in the range of 1∼20, 5∼50, 10∼500 and 10∼800 ohm/sq, respectively, for 30 nm, 22nm, 12 nm and 4 nm thick films.

The carbon films produced according to the invention particularly show an electrical resistance of ≤ 30 kohm/sq, in particular ≤ 20 kohm/sq, ≤ 800 ohm/ sq, preferably ≤ 500 ohm/sq, more preferably ≤ 200 ohm/sq, more preferably ≤ 100 ohm/sq, preferably ≤ 50 ohm/sq, and most preferably ≤ 15 ohm/sq. The electrical resistance is preferably at least 1 ohm/sq, more preferably ≥ 10 ohm/sq. The produced carbon films preferably have a sheet resistance of at most 30 kohm/sq, preferably 0.5-20 kohm/sq, 20-500 ohm/sq, 10-200 ohm/sq or 1-15 ohm/sq. Since the electrical resistance of the carbon films produced according to the invention in a certain way (even if to a smaller extent than the films of the prior art) depends on the thickness, the electrical resistance values indicated therein refer to, as far as not otherwise noted, carbon films having a thickness of ≤ 30 nm, preferably ≤ 20 nm and more preferably to a film thickness of 30 nm.

As a carbon source, according to the invention, discotic precursors are used. It is thereby possible by means of the method of the invention to easily apply a solution of these discotic precursors to the substrate and subsequently heat them out to a carbon film. The use of technically more difficult methods, as for example vapor deposition or the like is not necessary. It was found out according to the invention that carbon film structures result from discotic precursors during heating, having excellent properties as shown herein. Thus, discotic precursors are particularly suitable for use in the fabrication of thin, highly transparent and conductive graphitic carbon films. Preferably, an optically transparent conductive carbon film is produced comprising a supermolecular assembly of discotic precursors.

Discotic precursors are any molecules or substances which have disc-like structures or subunits. Discotic precursors are particularly flat molecules having a size in x and y dimension which is considerably higher than their size in z dimension, e.g. at least 5 times higher or at least 10 times higher. In particular, discotic precursors have oligocyclic aromatic units, preferably at least 3, more preferably at least 4, and most preferably at least 5 or ar least 10 aromatic cycles, in particular annealed aromatic cycles. Upwardly, the size is preferably chosen in a way that a sufficient workability is given. Preferably, the discotic precursors used show a maximum of 200, especially a maximum of 100 and especially preferred a maximum of 50 aromatic cycles, in particular poly-condensed rings.

Preferably, the aromatic cycles are pure aromatic hydrocarbon cycles without any heteroatoms. However, it is also possible to employ discotic precursors having one or more heteroatoms, in particular O, N, S or P within their ring structures. Preferably, discotic precursors have planar, disc-like polyaromatic cores that can self assemble into a supermolecular assembly. The discotic precursors can show side groups, e.g. alkyl chains, especially C₁₀-C₂₀ alkyl chains for the improvement of the solubility.

Discotic precursors suitable for use in the present application are for example oligocyclic aromatic hydrocarbons, exfoliated graphites, pitches, heavy oils, discotic liquid crystals etc. Generally, all discotic precursors having units of polyaromatic structures can be employed. Discotic structures are for example described in Watson et al., Chem. Rev. 2001, 101, 1267-1300.

The discotic precursors are flat layered and aligned like slices on the surface. In non-discotic systems, the desired alignment is not effected. Particularly preferred are superphenalenes or hexa benzocoronenes (HBC) or derivatives thereof, in particular derivatives having C₁₀-C₂₀ alkyl groups as substituents such as C96-C₁₂ or HBC-PhC₁₂. Further preferred are pitches and heavy oils, particularly those from coal tar or petroleum tar or exfoliated graphites, particularly graphite sheets obtained by modification of physically exfoliated graphite or chemical oxidation of graphite particles. Pitches are composed of high molecular cyclic hydrocarbons and heterocycles. Since graphite oxide is more reactive, the linkage temperature is lower using this system as using pure hydrocarbons.

The transparency and conductivity of the obtained carbon film depend on the film structure, which in turn is dependent on the type of precursors used. Only the provision of discotic precursors yields the desired result. Carbon films prepared from discotic precursors, such as superphenalenes or hexabenzocoronenes (HBC) derivatives, show both high conductivity and transparency owing to a pre-organization of these molecules during film formation which lead to unique carbon structures after carbonization. The structure of the inventive carbon films, determined e.g. by high-resolution transmission electron microscopy (HRTEM) or Raman spectroscopy, consist of ordered, tightly packed graphene layers, which are formed by fusion or linkage of the molecules which are due to their discotic structure, already orderely layered on the surface.

The use of discotic precursors is essential to result in a graphene film with graphenes arranged face on on the substrate. In particular, discotic molecules form strong interactions with adjacent discotic molecules and with the surface of substrates due to their large aromatic areas. By these strong interactions, discotic molecules are pre-organized during application in a solvent into graphene-like molecular sheets, which then can be fused into large graphene films. The ability of discotic molecules to pre-organize on a surface seems to be an essential feature for forming carbon films having said desired properties. The pre-organization of discotic molecules on a surface of substrates can be proven by STM characterizations. "Facon-on" alignment of graphene sheets on substrates can also be observed by SEM (scanning electron microscopy).

The transparent film preferably has a thickness of at most 20 nm, preferably at most 13 nm. In a particularly embodiment, the thickness of the film is 3.5 nm or smaller. Steps (i) and (ii) can be repeated at least once in order to obtain the desired film thickness.

A transparent substrate is preferably used according to the invention, especially a substrate having a transmittance of at least 50%, more preferably of at least 70% and most preferably of at least 90% of the interesting wave length, e.g. the wave length of from 500 to 800 nm, in particular from 600 to 700 nm and preferably at 700 nm and at a substrate thickness of ≥ 100 µm, in particular of at least 1 mm. Suitable substrate materials are for example glass, quartz, sapphire or transparent polymers, in particular heat-resistant transparent polymers.

The film production process of the invention is extremely simple. In a first step, a solution of discotic precursors is provided. The solution is then coated onto a substrate, preferably, a transparent substrate such as glass, quartz or sapphire or transparent heat resistant polymers. Coating may be accomplished by any known process. It is preferred to apply for example spin coating, spray coating or zone casting processes. In the process, the thickness of carbon films can easily be controlled by the concentration of the discotic precursor solution and film size is only limited by the size of substrates. Due to the disk-like structure of the discotic precursor used, they are arranged in an orderly manner on the surface.

In a second step, the coated substrate is heated to temperature of about 400-2000°C, in particular 500-1500°C, preferably 900-1100°C under an inert or reducing protective gas, preferably under inert gas. For example, noble gas such as argon or helium or another inert gas such as nitrogen or a reducing gas such as hydrogen or ammonia can be used as a protective gas. The heating is thereby preferably performed under a protective atmosphere, i.e. an atmosphere which consists only of the inert protective gas, or reducing gas or mixture of inert and reducing gas and does not contain any other substances. It is especially preferred according to the invention that a heat treatment comprising a slow increase in temperature or/and a stepwise increase in temperature is carried out. By the heating and especially by a slow heating, the discotic precursors aligned in flat layered structures are connected with each other. Higher structures are achieved therewith until graphene films are obtained. The heating is preferably effected so slowly that no melting occurs and that especially the temperature remains below the isotropic temperature. In a preferred embodiment, the heat treatment is effected in a slow heating, whereby the temperature increasing rate is ≤ 10°C/min., especially ≤ 5°C/min. and preferably 2 to 3°C/ min. In addition, steps for maintaining the temperature can be intended in the heat treatment, i.e. an increasing rate of 0°C/min. for a particular time period, e.g. for 10 min. to 10 h, preferably 30 min. to 5 h.

In an especially preferred embodiment, the coated substrate is first slowly heated to a temperature between 200 and 450°C and then kept at this temperature for 30 min. to 5 h, subsequently further increased to a temperature in the range of 550°C to 650°C, again kept for 30 min. to 5 h and subsequently slowly increased to a temperature within the range of 1000 to 1100°C and kept for a period of 30 min. to 2 h.

It is possible by means of the inventive method to obtain a unique carbon film with advantageous properties. A further subject-matter of the invention is therefore a transparent conductive carbon film. The transparent conductive carbon film according to the invention preferably has the herein given features.

Preferably used is the transparent conductive carbon film as an electrode. Especially preferred is the application as hole-collecting electrode in a solar cell.

Due to its improved characteristics, the transparent carbon film of the invention is particularly suitable for use in liquid crystal displays, flat panel displays, plasma displays, touch panels, electronic ink application, organic light emitting diodes and solar cells.

The invention further comprises optoelectronic devices having at least one electrode comprising a carbon film as described herein.

The present invention relates to an optically transparent conductive carbon-based film which is suitable for use as an electrode in optoelectronic devices etc. Further, the invention relates to a process for the production of the transparent conductive carbon film and the use thereof in electronic devices. Organic solar cells using transparent conductive carbon film display comparable performance with cells using ITO. These carbon films show high thermal and chemical stability, ultra-smooth surface, and good adhesion to substrates. This unique combination of optical, electrical and chemical properties of these carbon films has great potential in various applications. In addition, the simple process for the fabrication of carbon films enables inexpensive and large-scale industrial manufacturing.

Thus, the invention also relates to an optoelectronic device comprising an electrode having a carbon film as described herein. The optoelectronic device preferably is a photodiode including solar cells, phototransistors, photomultipliers, integrated optical circuit (IOC) elements, photoresistors, injection laser diodes or light-emitting diodes.

Particularly, the transparent conductive carbon films according to the present invention can be used as transparent electrodes in optoelectronic devices, such as solar cells. The conductivity of the transparent carbon film is preferably in the range of from 100 to 3200 S/cm which makes such films suitable as electrodes in optoelectronic devices. Preferably, the transparent conductive film is used as anode, e.g. in a solar cell device. The particularly preferred the transparent conductive carbon film is used as window electrode in optoelectronic devices. Thereby, the up to know widely used transparent electrode ITO can be substituted.

Said conductive carbon films according to the invention further show an excellent transparency meeting the demands of modern optoelectronic devices. A further embodiment of the present invention therefore is the use of the transparent conductive carbon films described herein as electrodes, in particular as electrodes for optoelectronic devices. The excellent conductivity and transparency in combination with high thermal and chemical stability as well as an ultra-smooth surface make the carbon films of the present invention suitable for optoelectronic devices, such as solar cells or organic light-emitting diodes (OLED). They are particularly suitable as window electrodes in solar cells.

The invention is further illustrated by the appended Figures and the following Examples.
**Figure 1** shows the transmittance spectrum of carbon films produced according to the invention on quartz. The curve corresponds to 30 nm, 22 nm, 12 nm and 4 nm thick carbon films, respectively (from the bottom up).
**Figure 2** shows AFM images (2 µm * 2 µm) of the surface of 4 nm (A)m 12 nm (B) and 30 nm (C) thick carbon films produced according to the invention. Four sectional plots are given below each image.
**Figure 3** shows a high-resolution transmission electron micrograph (HRTEM) image (A) and a Raman spectrum (B), proofing the graphitic structure of the carbon films.
**Figure 4** shows a solar cell using a carbon film/quartz substrate as an anode.
**Figure 5** shows a solar cell using a graphene-structured carbon film as anode and Au as cathode (A) and the energy level diagram of a graphene/TiO2/dye/spiro-OMeTAD device (B) as well as the current voltage characteristics (C).
**Figure 6** shows the structures of two preferred discotic precursors, namely of HBC-PhC12 and of C96.

### Examples

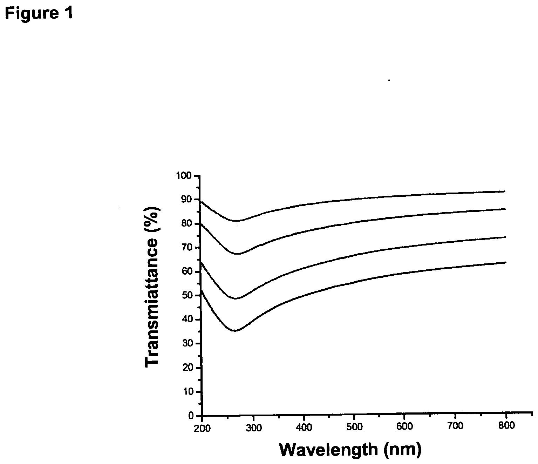

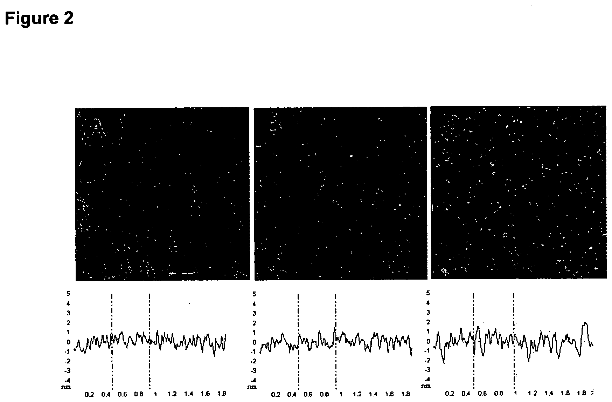

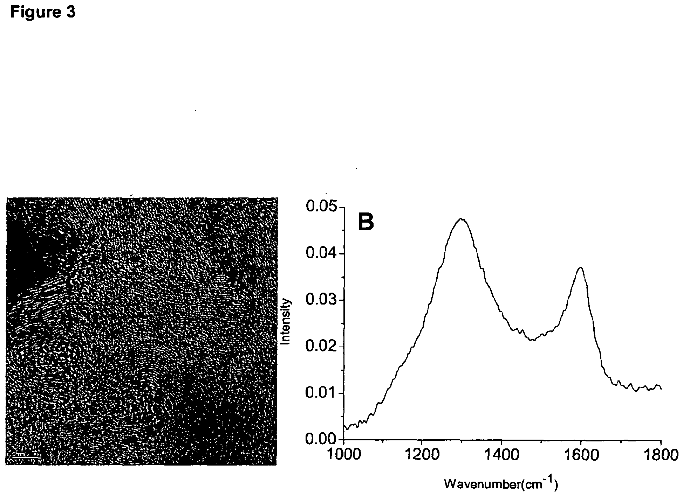

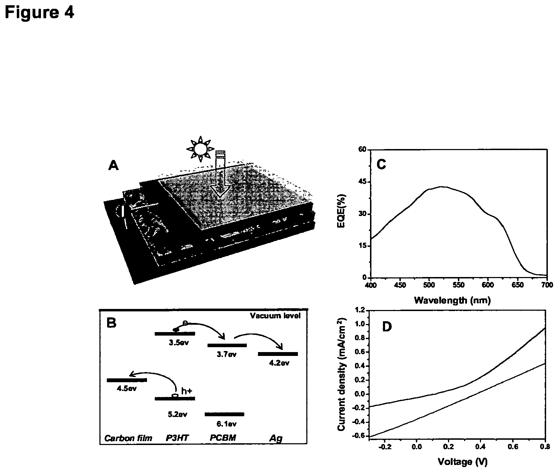

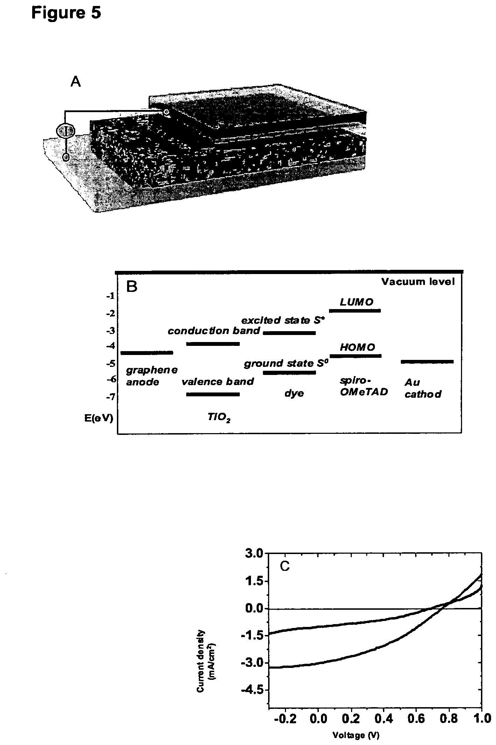

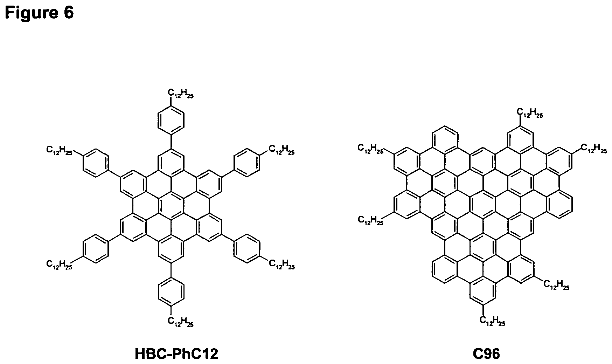

1. Solutions of discotic precursors C96-C₁₂, HBC-PhC₁₂, oxided graphites and coal tar pitches, respectively, are coated onto a quartz substrate and the substrate is then heated to about 1100 °C under Ar protection.
2. The thickness of carbon films can be controlled by the concentration of solution; and the size of film is only limited by the size of substrates. Depending on the concentration of the solution applied transparent carbon-based films are obtained having a thickness of 50 nm, 30nm, 13 nm or 3.5 nm.
3. At a wavelength of ∼700 nm, a carbon film having a thickness of 30 nm, 22 nm, 12 nm and 4 nm has a transmittance of 61%, 72%, 84% and 92%, respectively (Fig.1). In addition, at a given film thickness, transmittance was somewhat dependent upon wavelength with a minimum at ∼260nm. This spectral feature is consistent with the carbon soot having a graphitic structure.
4. The carbon films have a highly smooth surface, free of any large aggregates, pinholes and cracks, which is important for fabrication of optoelectronic devices in high quality. The average surface roughness (Ra) of carbon films with a thickness of 4nm, 12nm and 30nm over a 2 µm * 2 µm area was around 0.4nm, 0.5nm and 0.7nm respectively (Fig. 2a, 2b and 2c).
5. The as-grown carbon films adhere strongly to substrates. These carbon films can keep intact even after long time bath sonication in ordinary organic solvents, and can pass laboratory Scotch-tape test. After immersing the carbon film/quartz into piranha solution (a mixture of concentrated sulfuric acid and H₂O₂, V:V=7:3) for 48 hours, the conductivity of films keep almost the same, demonstrating the chemical stability of carbon films against strong acid and oxidative agent.
6. Structure of graphitic carbon films is confirmed by high-resolution transmission electron micrograph (HRTEM) (Fig. 3a) and Raman spectroscopy (Fig. 3b). Carbon films show clearly graphitic domains distributed in the film. The layer-to-layer distance was around 0.35nm, close to the value of the (002) lattice spacing of graphite. Two typical bands at approximately 1598cm⁻¹ (G band) and 1300cm⁻¹ (D band) are observed, assigned to graphitic carbon and disordered carbon, respectively.
7. Sheet resistance of carbon films is in the range of 5 ohm/sq-30 kohm/sq, dependent of film thickness, precursors, substrates type and heating condition etc. For example, sheet resistance of 30nm-thick carbon films grown from C96-C₁₂ on SiO₂/Si substrates is in a range of 5-50 ohm/sq, and that of 10 nm-thick carbon films grown from oxidized graphite is in the range of 500-1500 ohm/sq.
8. A solar cell based on a blend of poly(3-hexyl)-thiophene (P3HT) (electron donor) and phenyl-C61-butyric acid methyl ester (PCBM) (electron acceptor) is fabricated using a carbon film/quartz as an anode (Fig. 4a, 4b). The highest external quantum efficiency (EQE) of around 43% is achieved at a wavelength of 520nm, comparable to the highest EQE value of 47% for a reference device, ITO/glass as anode, under similar condition (Figure 4c). The current-voltage (I-V) characteristic (Fig. 4d) of the carbon film based device under monochromatic light of 510nm shows a distinct diode behavior. A short-circuit photocurrent density (I_{sc}) of 0.052mA/cm² is observed with open-circuit voltage (V_{oc}) of 0.13V, calculated filling factor (FF) of 0.23, and overall power conversion efficiency of 1.53%. When illuminated with simulated solar light, the cell gives I_{sc} of 0.36mA/cm², V_{oc} of 0.38V, FF of 0.25 and an efficiency of 0.29%. Obviously, in comparison with ITO based cell, which shows V_{oc} of 0.41V, I_{sc} of 1.00mA/cm², FF of 0.48, and an efficiency of 1.17%. The cell performance is comparable to the ITO based cell.
9. A dye-sensitized solid solar cell based on spiro-OMeTAD (as a hole transport material) and porous TiO₂ (for electron transport) was fabricated using the graphene-structured carbon film as anode and Au as cathode (Figure 5a). This graphene-structured carbon film was prepared from exfoliated graphite. Figure 5b shows the energy level diagram of graphene/TiO₂/dye/spiro-OMeTAD/Au device. Since the calculated work function of graphene is 4.42 eV and the mostly reported work function of HOPG is 4.5 eV, it is reasonable to presume that the work function of as prepared graphene-structured carbon film is close to that of FTO electrode (4.4 eV). The electrons are firstly injected from the excited state of the dye into the conduction band of TiO₂ and then reach the graphene-structured carbon electrode via a percolation mechanism inside the porous TiO₂ structure. Meanwhile, the photooxidized dyes are regenerated by the spiro-OMeTAD hole conducting molecules. The current-voltage (I-V) characteristics (Figure 5c, black curve) of the device under illumination of simulated solar light showed a short-circuit photocurrent density (I_{sc}) of 1.01 mA/cm² with an open-circuit voltage (V_{oc}) of 0.7 V, calculated filling factor (FF) of 0.36, and overall power conversion efficiency of 0.26 %. For comparison, an FTO-based cell was fabricated and evaluated with the same procedure and device structure by replacing graphene film electrode with FTO. The FTO-based cell gave I_{sc} of 3.02 mA/cm², V_{oc} of 0.76V, FF of 0.36 and an efficiency of 0.84 % (Figure 5c, red curve). The cell performance is comparable to the FTO based cell.
10. Using HBC-PhC12 (see the chemical structure shown in Fig. 6) as starting compound, its solution in THF (5 mg/ml) was spin-coated on quartz substrate to obtain homogeneous organic film. The film was heat treated in argon at 400°C for 2 hours and then 600°C for 2h and finally 1100°C for 30 min to obtain carbon film with a thickness of 20 nm. The transparency of the film at 500 nm is 65%, and the conductivity is 68 S/cm⁻¹.
11. Using C96 (see the chemical structure shown in Fig. 6) as starting compound, its solution in THF (2.5 mg/ml) was spin-coated on quartz substrate to obtain homogeneous organic film. The film was heat treated in argon at 400°C for 2 hours and then 1100°C for 30 min to obtain carbon film with a thickness of 10 nm. The transparency of the film at 500 nm is 81%, and the conductivity is 160 S/cm⁻¹.
12. Using C96 (see the chemical structure shown in Fig. 6) as starting compound, its solution in THF (5 mg/ml) was spin-coated on quartz substrate to obtain homogeneous organic film. The film was heat treated in argon at 400°C for 2 hours and then 1100°C for 30 min to obtain carbon film with a thickness of 18 nm. The transparency of the film at 500 nm is 76%, and the conductivity is 160 S/cm⁻¹.
13. Using exfoliated graphite oxide as starting compound, its solution in water (1.5 mg/ml) was dip-coated on quartz substrate to obtain homogeneous organic film. The film was heat treated in argon and hydrogen at 400°C for 30 hours and then 1100°C for 30 min to obtain carbon film with a thickness of 10 nm. The transparency of the film at 500 nm is 71%, and the conductivity is 520 S/cm⁻¹.

## Claims

1. A method for the production of a transparent conductive carbon film comprising the steps
(i) coating of a solution of discotic precursors onto a substrate and
(ii) heating the coated substrate under a protective gas to a temperature of from 400-2000°C,
wherein the produced transparent carbon film has a transmittance in the range of 60-95%, for a carbon film having a thickness of 30 nm-4 nm at a wavelength of 700 nm and wherein the produced carbon film has a sheet resistance of at most 30 kohm/sq, and
wherein the discotic precursors are selected from superphenalenes, hexabenzocoronenes (HBC), ovalenes, coronenes, perylenes, pyrenes, and their derivatives; pitches, heavy oils from coal or petroleum; or exfoliated graphite from chemical or physical exfoliation of any graphite or from graphite oxide.

2. The method according to claim 1, wherein in step
(i) flat-aligned discotic structures are formed.

3. The method according to claim 1 or 2, wherein the produced carbon film has a sheet resistance of at most 20 kohm/sq.

4. The method according to any one of the preceding claims, wherein the produced carbon film has a thickness of ≤ 20 nm and/or wherein the substrate is a transparent substrate.

5. The method according to any one of the preceding claims, wherein the substrate is composed of glass, quartz, sapphire or a polymer.

6. The method according to any one of the preceding claims, wherein the coating of the discotic precursors onto the substrate is performed by spin coating, spray coating, dip coating, zone-casting, lifting deposition or Langmuir-Blodgett and/or wherein the inert gas is selected from nitrogen, or a noble gas, in particular Ar, or a reducing gas, in particular H₂.

7. The method according to any one of the preceding claims, wherein the coated substrate is heated to a temperature of from 500-1500°C.

8. The method according to claim 2, **characterized in that** a linkage of the flat-aligned discotic structures is effected by heating.

9. The method according to any one of the preceding claims, **characterized in that** in step (ii) the temperature is slowly increased so that no melting of the discotic precursors is effected and/or **characterized in that** the heating is conducted at a heating rate of less than or equal to 10°C/min., in particular ≤ 5°C/min.

10. A transparent conductive carbon film obtained by the method of any one of claims 1-9.

11. An electrode comprising a carbon film according to claim 10.

12. Use of an electrode according to claim 11 for liquid crystal displays, flat-panel displays, plasma displays, touch panels, electronic ink applications, lasers, optical communication devices, light-emitting diodes or solar cells.

13. Optoelectronic device comprising an electrode according to claim 11.

14. Optoelectronic device according to claim 13 being photodiodes, including solar cells, phototransistors, photomultipliers, integrated optical circuit (IOC) elements, photoresistors, injection laser diodes or light-emitting diodes.

## Patentansprüche

1. Verfahren zur Herstellung eines transparenten leitfähigen Kohlenstofffilms, umfassend die Schritte
(i) Beschichten einer Lösung von diskotischen Vorläufern auf ein Substrat und
(ii) Erhitzen des beschichteten Substrats unter einem Schutzgas auf eine Temperatur von 400-2000 °C,
wobei der hergestellte transparente Kohlenstofffilm eine Durchlässigkeit in dem Bereich von 60-95 % für einen Kohlenstofffilm mit einer Dicke von 30 nm - 4 nm bei einer Wellenlänge von 700 nm aufweist und wobei der hergestellte Kohlenstofffilm einen Schichtwiderstand von höchstens 30 kOhm/sq aufweist und
wobei die diskotischen Vorläufer ausgewählt sind aus Superphenalenen, Hexabenzocoronenen (HBC), Ovalenen, Coronenen, Perylenen, Pyrenen und ihren Derivaten; Pechen, Schwerölen aus Kohle oder Erdöl; oder exfoliertem Graphit durch chemische oder physikalische Exfolierung von jedem Graphit oder von Graphitoxid.

2. Verfahren nach Anspruch 1, wobei in Schritt (i) flach ausgerichtete diskotische Strukturen gebildet werden.

3. Verfahren nach Anspruch 1 oder 2, wobei der hergestellte Kohlenstofffilm einen Schichtwiderstand von mindestens 20 kOhm/sq aufweist.

4. Verfahren nach einem der vorhergehenden Ansprüche, wobei der hergestellte Kohlenstofffilm eine Dicke von ≤ 20 nm aufweist und/oder wobei das Substrat ein transparentes Substrat ist.

5. Verfahren nach einem der vorhergehenden Ansprüche, wobei das Substrat aus Glas, Quarz, Saphir oder einem Polymer besteht.

6. Verfahren nach einem der vorhergehenden Ansprüche, wobei das Beschichten der diskotischen Vorläufer auf das Substrat durch Schleuderbeschichtung, Sprühbeschichtung, Tauchbeschichtung, Zonengießen, Lifting-Abscheidung oder Langmuir-Blodgett durchgeführt wird und/oder wobei das Inertgas ausgewählt ist aus Stickstoff oder einem Edelgas, insbesondere Ar, oder einem reduzierenden Gas, insbesondere H₂.

7. Verfahren nach einem der vorhergehenden Ansprüche, wobei das beschichtete Substrat auf eine Temperatur von 500-1500 °C erhitzt wird.

8. Verfahren nach Anspruch 2, **dadurch gekennzeichnet, dass** eine Verknüpfung der flach ausgerichteten diskotischen Strukturen durch Erhitzen bewirkt wird.

9. Verfahren nach einem der vorhergehenden Ansprüche, **dadurch gekennzeichnet, dass** in Schritt (ii) die Temperatur langsam erhöht wird, so dass kein Schmelzen der diskotischen Vorläufer bewirkt wird und/oder **dadurch gekennzeichnet, dass** das Erhitzen mit einer Aufheizrate von weniger als oder gleich 10 °C/min, insbesondere ≤ 5°C/min, durchgeführt wird.

10. Transparenter leitfähiger Kohlenstofffilm, erhalten durch das Verfahren nach einem der Ansprüche 1 bis 9.

11. Elektrode, umfassend einen Kohlenstofffilm nach Anspruch 10.

12. Verwendung einer Elektrode nach Anspruch 11 für Flüssigkristall-Bildschirme, Flachbildschirme, Plasmabildschirme, Touch-Panels, elektronische Tintenanwendungen, Laser, optische Kommunikationsvorrichtungen, lichtemittierende Dioden oder Solarzellen.

13. Optoelektronische Vorrichtung, umfassend eine Elektrode nach Anspruch 11.

14. Optoelektronische Vorrichtung nach Anspruch 13, die Photodioden darstellt, einschließlich Solarzellen, Phototransistoren, Photovervielfacher, IOC-Elemente (Integrated Optical Circuit), Photowiderstände, Injektionslaserdioden oder lichtemittierende Dioden.

## Revendications

1. Méthode pour la production d'un film de carbone conducteur transparent comprenant les étapes suivantes
(i) revêtement d'une solution de précurseurs discotiques sur un substrat et
(ii) chauffage du substrat revêtu sous un gaz protecteur à une température de 400-2000°C,
dans lequel le film de carbone transparent produit a une transmittance dans la gamme de 60-95%, pour un film de carbone ayant une épaisseur de 30 nm-4 nm à une longueur d'onde de 700 nm et dans lequel le film de carbone produit a une résistance de feuille d'au plus 30 kohm/sq, et
dans lequel les précurseurs discotiques sont choisis parmi les superphénalènes, les hexabenzocoronènes (HBC), les ovalènes, les coronènes, les pérylènes, les pyrènes et leurs dérivés ; les poix, les huiles lourdes de charbon ou de pétrole ; ou le graphite exfolié par l'exfoliation chimique ou physique de tout graphite ou de l'oxyde de graphite.

2. Méthode selon la revendication 1, dans laquelle, à l'étape (i), des structures discotiques alignées à plat sont formées.

3. Méthode selon la revendication 1 ou 2, dans laquelle le film de carbone produit a une résistance de feuille d'au plus 20 kohm/sq.

4. Méthode selon l'une quelconque des revendications précédentes, dans laquelle le film de carbone produit a une épaisseur de ≤ 20 nm et/ou dans lequel le substrat est un substrat transparent.

5. Méthode selon l'une des revendications précédentes, dans laquelle le substrat est composé de verre, de quartz, de saphir ou d'un polymère.

6. Méthode selon l'une quelconque des revendications précédentes, dans laquelle le revêtement des précurseurs discotiques sur le substrat est effectué par revêtement par centrifugation, revêtement par pulvérisation, revêtement par immersion, coulée par zone, dépôt par levage ou Langmuir-Blodgett et/ou dans lequel le gaz inerte est choisi parmi l'azote, ou un gaz noble, en particulier Ar, ou un gaz réducteur, en particulier H₂.

7. Méthode selon l'une quelconque des revendications précédentes, dans laquelle le substrat revêtu est chauffé à une température de 500-1500°C.

8. Méthode selon la revendication 2, **caractérisé en ce qu'**une liaison des structures discotiques alignées à plat est effectuée par chauffage.

9. Méthode selon l'une quelconque des revendications précédentes, **caractérisé en ce que** dans l'étape (ii), la température est lentement augmentée de sorte qu'aucune fusion des précurseurs discotiques n'est effectuée et/ou **caractérisé en ce que** le chauffage est effectué à une vitesse de chauffage inférieure ou égale à 10°C/min, en particulier ≤ 5°C/min.

10. Film de carbone conducteur transparent obtenu par la méthode de l'une quelconque des revendications 1 à 9.

11. Electrode comprenant un film de carbone selon la revendication 10.

12. Utilisation d'une électrode selon la revendication 11 pour des écrans à cristaux liquides, des écrans plats, des écrans à plasma, des écrans tactiles, des applications d'encre électronique, des lasers, des dispositifs de communication optique, des diodes électroluminescentes ou des cellules solaires.

13. Dispositif optoélectronique comprenant une électrode selon la revendication 11.

14. Dispositif optoélectronique selon la revendication 13, à savoir des photodiodes, y compris des cellules solaires, des phototransistors, des photomultiplicateurs, des éléments de circuits optiques intégrés (IOC), des photorésistances, des diodes laser à injection ou des diodes électroluminescentes.
